Europäisches Patentamt

European Patent Office

Office européen des brevets

(11) Veröffentlichungsnummer: **0 391 235**
**A1**

(12) **EUROPÄISCHE PATENTANMELDUNG**

(21) Anmeldenummer: **90105939.4**

(22) Anmeldetag: **28.03.90**

(51) Int. Cl.5: **H03F 1/32, H03G 7/08**

(30) Priorität: **04.04.89 EP 89105905**

(43) Veröffentlichungstag der Anmeldung:
**10.10.90 Patentblatt 90/41**

(84) Benannte Vertragsstaaten:
**AT BE CH DE DK ES FR GB GR IT LI LU NL SE**

(71) Anmelder: **Siemens Aktiengesellschaft**
**Wittelsbacherplatz 2**
**D-8000 München 2(DE)**

(72) Erfinder: **Peterknecht, Klaus, Dipl.-Ing.**
**Graubündnerstrasse 49**
**D-8000 München 71(DE)**
Erfinder: **Simon, Ulrich**
**Kerschensteinerstrasse 88**
**D-8034 Germering(DE)**
Erfinder: **Ens, Hermann, Dr.-Ing.**
**Ahornstrasse 30**
**D-8043 Unterföhring(DE)**

(54) **Analoger Vorverzerrer.**

(57) Ein analogen Vorverzerrer (6) für die Sende/Empfangseinrichtungen eines digitalen Nachrichtenübertragungssystem mit komplexer Amplitudenmodulation unter Gewährleistung guter Leistungsfähigkeit bei einer schaltungstechnisch einfacheren Lösung.

Hierzu wird eine Realisierung mit nur einem Übertragungsweg vorgesehen mit einem ein- oder mehrstufigen, rückgekoppelten Verstärker (9), in dessen Rückkopplungsweg eine Nichtlilnearität (10) mit signalleistungsabhängigem Gegenkopplungsfaktor eingeschaltet ist.

FIG 3

## Analoger Vorverzerrer

Die Erfindung bezieht sich auf einen analogen Vorverzerrer für die Sende-/Empfangseinrichtungen eines digitalen Nachrichtenübertragungssystems mit komplexer Amplitudenmodulation, insbesondere Quadraturamplitudenmodulation.

Um immer mehr Informationen pro Zeit- und Frequenz band übertragen zu können, wird in modernen Digital-Richtfunksystemen mit Quadraturamplitudenmodulation die Modulationsstufenzahl immer weiter erhöht. Mit dieser zunehmend verfeinerten Quantisierung der Modulation dürfen nurmehr immer kleinere Signalverfälschungen, beispielsweise bedingt durch die Nichtlinearität des Sendeverstärkers oder auch anderer Systemkomponenten, zugelassen werden. Da in Sendeverstärkern geringste Nichtlinearität in der Regel nur mit großem Aufwand und damit verminderter Wirtschaftlichkeit erreichbar ist, werden im Richtfunksender sogenannte Vorverzerrer (predistorter) eingesetzt. Diese erzeugen eine Nichtlinearität, die invers sein soll zur Nichtlinearität des Sendeverstärkers und der übrigen nichtlinearen Systemkomponenten. Damit wird eine Kompensation der Nichtlinearität erzielt, die Signalübertragung verbessert, die Forderungen an den Sendeverstärker reduziert und damit die Wirtschaftlichkeit des Systems erhöht. Eine solche Einrichtung mit einem Vorverzerrer zur Linearisierung eines Leistungsverstärkers für ein digitales Datensystem ist beispielsweise aus der US-PS 4 291 277 bekannt.

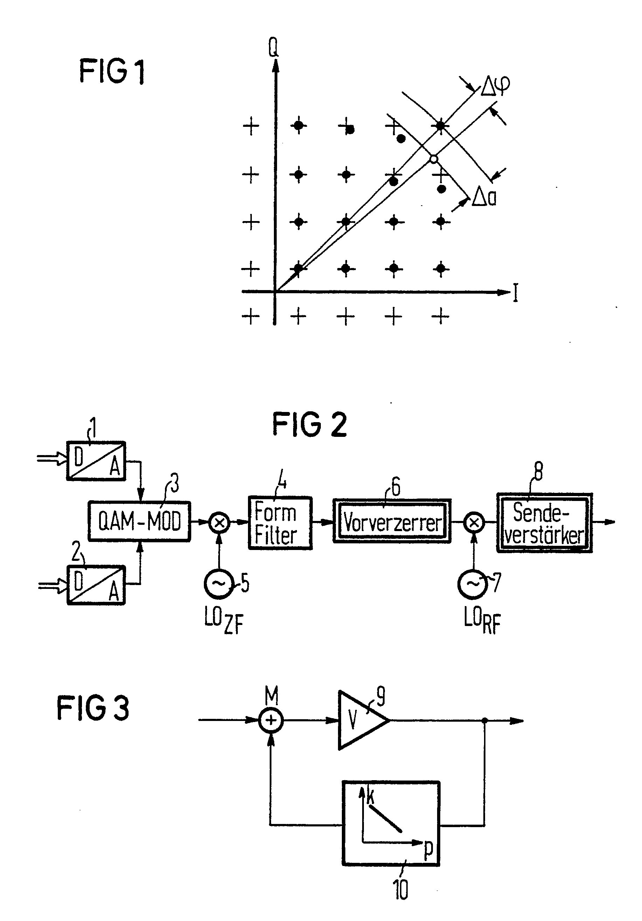

Die Nichtlinearität des Sendeverstärkers wirkt durch zwei Effekte signalverfälschend, nämlich durch die Amplitudenkompression (AM-AM) und durch die Phasenkonversion (AM-PM). Die Größe beider Effekte hängt von der Ansteuerleistung des Sendeverstärkers ab. Figur 1 zeigt, wie diese beiden Effekte ein mit Qua draturamplitudenmodulation (QAM) beaufschlagtes Signal verfälschen können. Es ist dabei ein Ausschnitt einer 16 QAM-Konstellation gezeigt, wobei die Soll-Lagen der Konstellationspunkte mit einem Kreuz, die Ist-Lagen mit einem Punkt eingezeichnet sind. Die Konstellationspunkte, d. h. die Signalwerte zum Abtastzeitpunkt werden, ausgehend von ihren Soll-Lagen, im Abstand zum Ursprung (Amplitude) komprimiert und in ihrer Phase gedreht. Dies trifft die äußersten Signalpunkte am stärksten.

Ein Vorverzerrer, der diese Effekte des Sendeverstärkers kompensieren soll, muß also gegenläufige (inverse) Amplitudenexpansion und eine gegenläufige Phasenkonversion aufweisen. Er hebt die Signalamplituden vor dem Sendeverstärker so weit an, daß zusammen mit dessen Kompression die gewünschte lineare Übertragung zustande kommt. Die Phase dreht er gegenläufig so weit, daß sich eine insgesamt amplitudenunabhängige Phase ergibt.

Figur 2 zeigt einen Verzerrer als Vorverzerrer im analogen Teil eines Richtfunksenders. Dabei gelangen die digitalen Daten (m-Bit) des I-und Q-Kanals über jeweils einen D/A-Wandler 1,2 an einen QAM-Modulator 3. Dessen Ausgangssignal wird mit der Frequenz eines Lokaloszillators 5 in die ZF-Ebene gebracht und gelangt über ein Formfilter 4 zum Vorverzerrer 6. Diesem ist ein weiterer Umsetzer für die RF-Ebene nachgeschaltet, der mit dem Sendeverstärker 8 verbunden ist.

Der Aufbau eines analogen Vorverzerrers als additiver Vorverzerrer erfordert einen Übertragungsweg mit geringstmöglicher Nichtlinearität, der also möglichst linear übertragen soll, und einen Übertragungsweg, der nur die für die Vorverzerrung nötige, zum zu entzerrenden Verstärker inverse Nichtlinearität aufweisen soll. Weiterhin sind erforderlich eine lineare Additionsstelle, die die Ausgangssignale des linearen und des nichtlinearen Übertragsweges addiert, ein phasenschiebendes Element, das unabhängig von Signalpegel und Frequenz einen ge zielten Abgleich der Phasenkonversion ermöglicht sowie ein Laufzeitelement, zum Beispiel eine Leitung definierter Länge, das den Laufzeitunterschied zwischen dem linearen und nichtlinearen Weg ausgleicht. Insgesamt ist der schaltungstechnische Aufwand eines solchen additiven Vorverzerrers groß.

Der Erfindung liegt die Aufgabe zugrunde, einen analogen Vorverzerrer zu schaffen, der bei gleicher Leistungsfähigkeit wie bisherige additive Vorverzerrer deren hohen schaltungstechnischen Aufwand meidet und statt dessen mit geringst möglichem Aufwand die zur Linearisierung nötige inverse Nichtlinearität erzeugt.

Diese Aufgabe wird mit einem analogen Vorverzerrer der eingangs genannten Art gemäß der Erfindung gelöst durch seine Realisierung mit nur einem Übertragungsweg mit einem ein- oder mehrstufigen, rückgekoppelten Verstärker, in dessen Rückkopplungsweg eine Nichtlinearität mit signalleistungsabhängigem Gegenkopplungsfaktor eingeschaltet ist.

Der Erfindung liegt dabei der Gedanke zugrunde, statt des additiven Vorverzerrers mit zwei parallelen Wegen einen Vorverzerrer mit nur einem Weg zu realisieren, der in diesem Weg den gewünschten linearen Übertragungsfaktor und zugleich die nötige Nichtlinearität erzeugt. Ein solcher Vorverzerrer läßt sich als multiplikativer Vorverzerrer bezeichnen.

Vorteilhafte Ausgestaltungen und Weiterbildungen des Erfindungsgegenstandes sind in den Unteransprüchen angegeben.

Nachstehend wird die Erfindung anhand von in der Zeichnung dargestellten Ausführungsbeispielen näher erläutert.

Es zeigen:

Fig. 3 einen analogen Vorverzerrer im Blockschaltbild,

Fig. 4 u. 5 das Frequenz- und Phasenverhalten des Vorverzerrers im Bodediagramm,

Fig. 6 - 19 verschiedene Ausführungsbeispiele der Anordnung des Gegenkopplungsnetzwerkes innerhalb des Rückkopplungsweges und

Fig. 20 ein Schaltungsbeispiel eines analogen Vorverzerrers mit detailierter Darstellung des Gegenkopplungsnetzwerkes (Nichtlinearität).

Figur 3 zeigt einen analogen Vorverzerrer im Blockschaltbild. Dabei ist ein im Übertragungsweg liegender Verstärker mit 9 bezeichnet. Er weist eine Rückkopplung auf, dargestellt durch das im Rückkopplungsweg liegende nichtlineare Netzwerk 10 mit dem Gegenkopplungsfaktor k. Am Verbindungspunkt M wird das Gegenkopplungsnetzwerk an den Übertragungsweg und damit an den Eingang des Verstärkers 9 angeschlossen.

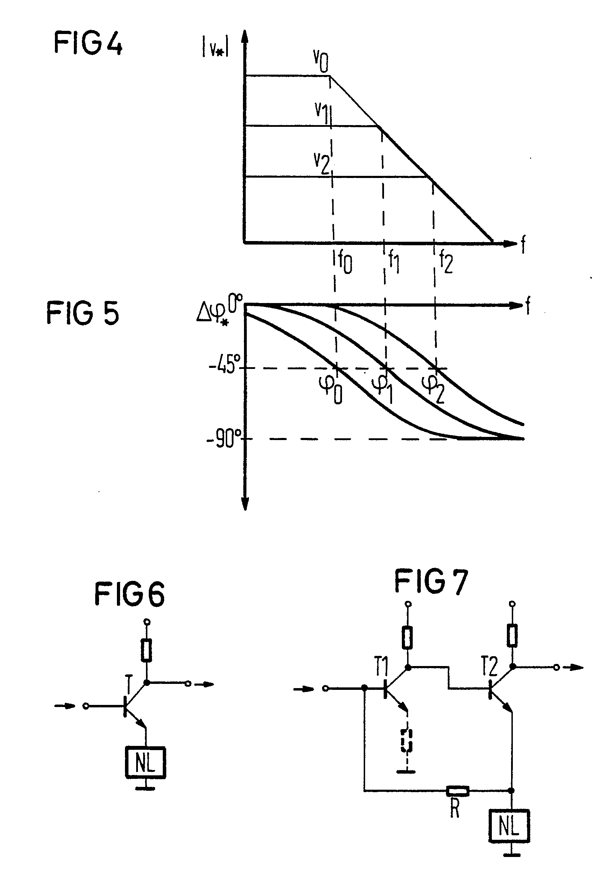

Die Wirkungsweise eines Vorverzerrers der vorstehend beschriebenen Art wird im folgenden erläutert: Der Verstärker sei im betrachteten Leistungsbereich linear. Er weise, ohne Rückkopplung, die Verstärkung $v_0$ auf. Sein Frequenzverhalten sei, für die Betrachtung vereinfachend angenommen, das eines Tiefpasses 1. Grades mit einer Grenzfrequenz $f_0$; $\phi_0$ sei der zugehörige Phasengang. Figur 4 zeigt dies in Form eines Bodediagramms. Wird der Verstäker linear, frequenzunabhängig gegengekoppelt, so verringert sich die resultierende Verstärkung $v_*$ der gegengekoppelten Schaltung mit steigendem Gegenkopplungsfaktor k auf einen Wert $v_1$, $v_2$, $v_3$,..., seine Grenzfrequenz steigt auf die Werte $f_1$, $f_2$, $f_3$. Sofern konstantes Verstärkungs-Bandbreite-Produkt angenommen werden kann, gilt:

$$v_0 \cdot f_0 = v_1 \cdot f_1 = v_2 \cdot f_2 = v_3 \cdot f_3 \ldots$$

Entsprechend verschieben sich auch die zugehörigen Phasenläufe von $\phi_0$ auf $\phi_1$, $\phi_2$, $\phi_3$ ...

Wird nun anstatt einer üblichen signalleistungsunabhängigen, z. B. ohmschen, Gegenkopplung eine leistungsabhängige Gegenkopplung verwendet, so werden resultierende Verstärkung, Grenzfrequenz und Phasengang abhängig sein von der übertragenen Signalleistung. Bei entsprechender Abhängigkeit des Gegenkopplungsfaktors k von der Signalleistung (vergleiche das Gegenkopplungsnetzwerk in Fig. 3) steigt die Verstärkung mit steigender Leistung. Der gegengekoppelte Verstärker weist also eine expandierende Kennlinie auf im Gegensatz zur komprimierenden Kennlinie des Sendeverstärkers. Zugleich tritt eine Phasenänderung in Abhängigkeit der Leistung auf und zwar wird mit steigender Leistung die Phase negativer. Damit in jedem gewünschten Fall und für jeden Sendeverstärker die benötigte Richtung der Phasenänderung zur Verfügung steht, müssen neben der negativen auch positive Phasenänderungen realisierbar sein. Dies ist möglich, wenn statt eines reellen, frequenzunabhängigen Gegenkopplungsfaktors k ein komplexer Gegenkopplungsfaktor verwendet wird, der Form:

$$k = \frac{p \cdot \alpha}{1 + p \cdot \beta} \qquad\qquad \text{mit } P = j\, 2\, \pi\, f.$$

Nachfolgend werden verschiedene Ausführungsbeispiele des Gegenkopplungsnetzwerkes (Nichtlinearität NL) innerhalb des Rückkopplungsweges beschrieben.

Figur 6 zeigt eine Ausführungsform mit einem Transistor T in Emitterschaltung als Verstärkungselement, bei der das Gegenkopplungsnetzwerk NL zwischen Emitteranschluß und Masse eingeschaltet ist.

Bei der Ausführungsform nach Figur 7 ist eine zweistufige Transistorschaltung aus zwei hintereinander geschalteten Transistoren T1 und T2 in Emitterschaltung vorgesehen, bei der das Gegenkopplungsnetzwerk NL zwischen dem Emitter des zweiten Transistors T2 und Masse eingeschaltet ist, wobei der Emitter des zweiten Transtistors T2 zugleich über einen ohmschen Widerstand R mit der Basis des ersten Transistors T1 verbunden ist.

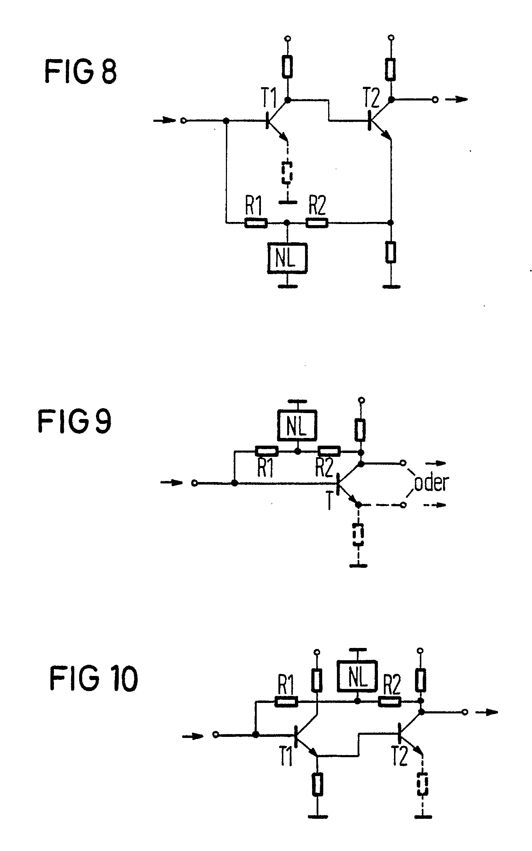

Figur 8 zeigt eine Ausführungsform mit einer zweistufigen Transistorschaltung in Emitterschaltung, bei der das Gegenkopplungsnetzwerk NL zwischen dem Verbindungspunkt eines zwischen dem Emitter des zweiten Transistors T2 und der Basis des ersten Transistors T1 liegenden ohmschen Spannungsteilers aus den Widerständen R1 und R2 und Masse eingeschaltet ist.

Eine ebenfalls einstufige Transistorschaltung mit einem Transistor T in Emitterschaltung zeigt Figur 9. Bei dieser liegt im Rückkopplungsweg zwischen Kollektor und Basis ein ohmscher Spannungsteiler aus den Widerständen R1 und R2, zwischen deren Verbindungspunkt und Masse das Gegenkopplungsnetzwerk NL eingeschaltet ist.

Das Ausführungsbeispiel nach Figur 10 zeigt eine zweistufige Transistorschaltung mit den Transistoren T1 und T2 in Emitterschaltung, wobei der Rückkopplungsweg vom Kollektor des zweiten Transistors T2 zur Basis des ersten Transistors T1 führt, in dem zwei ohmsche Widerstände R1 und R2 eingeschaltet sind, zwischen deren Verbindungspunkt und Masse das Gegenkopplungsnetzwerk NL liegt.

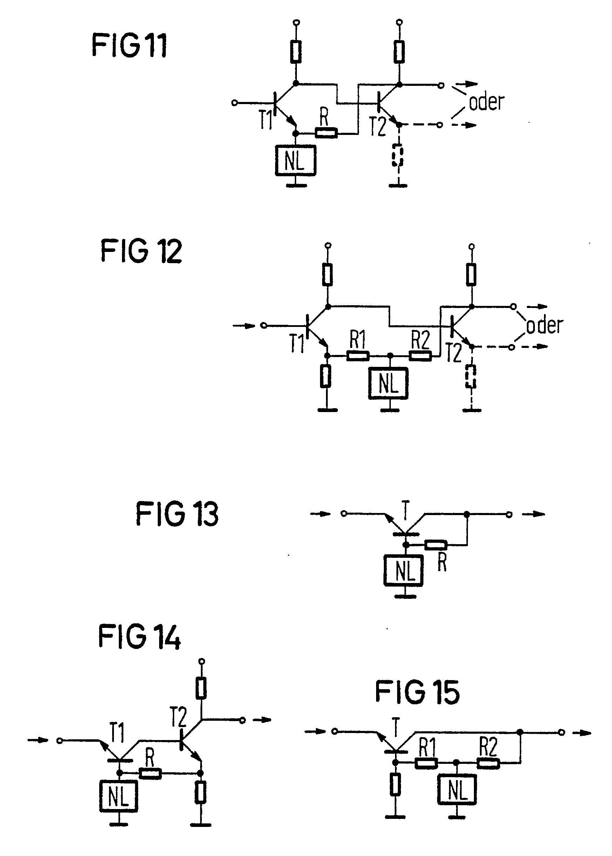

Eine ebenfalls zweistufige Transistorschaltung in Emitterschaltung enthält das Ausführungsbeispiel nach Figur 11. Bei diesem ist ein Rückkopplungsweg vom Kollektor des zweiten Transistors T2 zum Emitter des ersten Transistors vorgesehen, in dem ein ohmscher Widerstand R liegt und wobei zwischen dem Verbindungspunkt des ohmschen Widerstandes und dem Emitter des ersten Transistors T1 und Masse das Gegenkopplungsnetzwerk NL eingeschaltet ist.

Das Ausführungsbeispiel nach Figur 12 ist ähnlich aufgebaut, jedoch liegt bei diesem im Rückkopplungsweg ein ohmscher Spannungsteiler aus den Widerständen R1 und R2, zwischen deren Verbindungspunkt und Masse das Gegenkopplungsnetzwerk NL eingeschaltet ist.

Figur 13 zeigt eine einstufige Transistorschaltung in Basisschaltung als Verstärkungselement, bei der zwischen Kollektor und Basis des Transistors T ein ohmscher Widerstand R und zwischen Basis und Masse das Gegenkopplungsnetzwerk NL eingeschaltet ist.

Eine zweistufige Transistorschaltung mit einem ersten Transistor T1 in Basisschaltung und einem mit diesem in Serie lie genden zweiten Transistor T2 in Emitterschaltung zeigt Figur 14. Der Emitter des zweiten Transistors T2 ist über einen Widerstand R mit der Basis des ersten Transistors verbunden, zwischen der und Masse das Gegenkopplungsnetzwerk NL eingeschaltet ist. Der Emitter des zweiten Transistors T2 liegt über einen weiteren ohmschen Widerstand an Masse.

Beim Ausführungsbeispiel nach Figur 15 mit einem Transistor T in Basisschaltung und einer Rückkopplung vom Kollektor zur Basis des Transistors über einen ohmschen Spannungsteiler aus den Widerständen R1 und R2 liegt das Gegenkopplungsnetzwerk zwischen dem Verbindungspunkt der beiden Widerstände R1 und R2 und Masse.

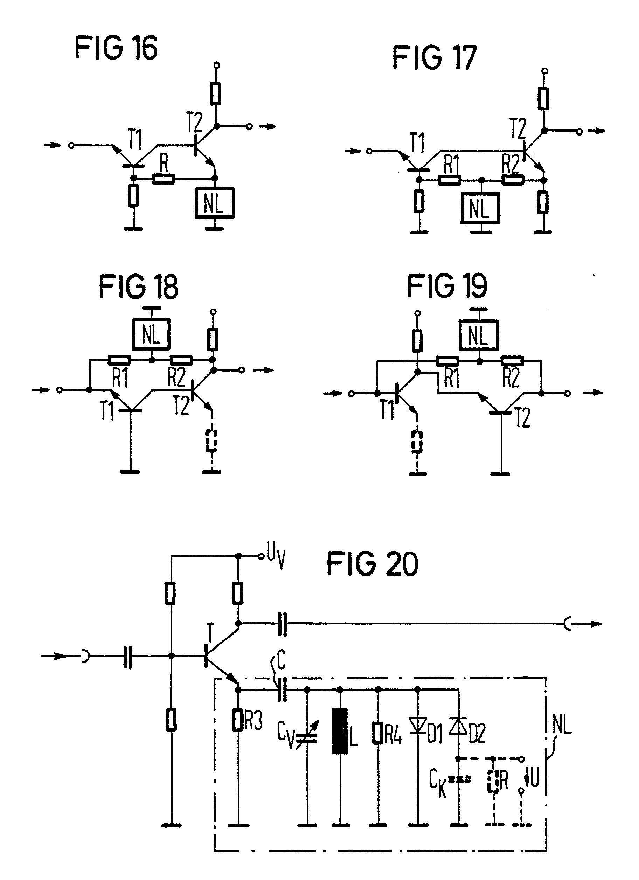

Eine dem Ausführungsbeispiel nach Figur 14 ähnliche Ausführungsform zeigt Figur 16. Bei dieser liegt jedoch das Gegenkopplungsnetzwerk NL zwischen dem über einen ohmschen Widerstand mit der Basis des ersten Transistors T1 verbundenen Emitter des zweiten Transistors T2 und Masse.

Bei einer weiteren zweistufigen Transistorschaltung nach Figur 17 mit einem ersten Transistor T1 in Basisschaltung und einem zweiten Transistor T2 in Emitterschaltung liegt im Rückkopplungsweg zwischen dem Emitter des zweiten Transistors T2 und der Basis des ersten Transistors T1 ein ohmscher Spannungsteiler aus den Widerständen R1 und R2, zwischen deren Verbindungspunkt und Masse das Gegenkopplungsnetzwerk NL eingeschaltet ist. Die Basis des ersten und der Emitter des zweiten Transistors liegen über jeweils einem ohmschen Widerstand an Masse.

Figur 18 zeigt ein Ausführungsbeispiel mit einer zweistufigen Transistorschaltung entsprechend den Figuren 16 und 17, bei dem sich jedoch der Rückkopplungsweg zwischen dem Kollektor des zweiten Transistors T2 und dem Emitter des ersten Transistors T1 befindet. Zwischen dem Verbindungspunkt zweier in diesem Weg liegender ohmscher Widerstände R1 und R2 und Masse ist das Gegenkopplungsnetzwerk NL eingeschaltet.

Beim Ausführungsbeispiel nach Figur 19 besteht die zweistufige Transitorschaltung aus einem ersten Transistor in Emitterschaltung und einem mit diesem Serie liegenden zweiten Transistor in Basisschaltung. Das Gegenkopplungsnetzwerk NL ist hierbei zwischen dem Verbindungspunkt eines zwischen dem Kollektor des zweiten Transistors T2 und der Basis des ersten Transistors T1 liegenden ohmschen Spannungsteilers aus den Widerständen R1 und R2 und Masse eingeschaltet.

Figur 20 zeigt ein bevorzugtes einfaches Ausführungsbeispiel einer Vorverzerrerschaltung, die in der eingangs beschriebenen Weise arbeitet. Sie besteht aus einer einstufigen Transistorschaltung, wobei der Transistor T in Emitterschaltung bei einem ausreichend großen Ruhestrom betrieben wird, so daß er alleine, ohne die nichtlineare Gegenkopplung, nur unwesentlich zur Gesamt-Nichtlinearität der Schaltung beiträgt. Von den Bauelementen dieser Schaltung sollen lediglich die innerhalb des strichliert gezeichneten Kästchens liegenden beschrieben werden, die das Gegenkopplungsnetzwerk (Emitterimpedanz) bilden. Dieses besteht aus einem ohmschen Widerstand R3 im Längszweig, der, neben seiner Wirkung auf das Signal, den Arbeitspunkt stabilisiert, einem Koppelkondensator C, der die nachfolgenden Bauelemente vom Gleichstrom entkoppelt und zu dem gegebenenfalls ein ohmscher Widerstand in Reihe geschaltet sein kann, aus einem weiteren ohmschen Widerstand R4 im Längszweig mit einem parallel geschalteten Diodennetzwerk aus zwei antiparallelen Dioden D1, D2, das als Nichtlinearität in der Gegenkopplung dient, sowie ferner aus einer dazu parallelen Induktivität L und einer ebenfalls parallelen abstimmbaren Kapazität $C_V$, z. B. eine Varaktordiode. Induktivität L und abstimmbare Kapazität $C_V$ dienen der Beeinflussung der signalleistungsabhängigen Phase (AM-PM). Der Widerstand R4 und das Diodennetzwerk aus den beiden Dioden D1 und D2 realisieren einen nichtlinearen Widerstand, der mit wachsender Signalleistung niederohmiger wird. Damit wird der Gegenkopplungsfaktor k ebenfalls mit zunehmender Leistung kleiner.

In Fig. 20 sind in strichlierter Darstellung weitere Ausgestaltungen im Bereich der beiden antiparallelen Dioden wiedergegeben. Dabei ist zum einen zwischen eine der beiden Dioden (gezeichnet für Diode D1) und Masse ein Koppelkondensator $C_K$ eingeschaltet. An dem Verbindungspunkt zwischen Diode und Koppelkondensator sind die antiparallelen Dioden D1, D2 mit einer Gleichspannung U vorgespannt. Zusätzlich kann zum Koppelkondensator $C_K$ ein ohmscher Widerstand R5 parallelgeschaltet sein. Eine andere Ausgestaltung besteht in der alleinigen Parallelschaltung von Koppelkondensator $C_K$ und ohmschen Widerstand R5.

Das Gegenkopplungsnetzwerk läßt sich selbstverständlich auch als Dioden- und Transistornetzwerk realisieren inclusive der jeweils notwendigen ohmschen, kapazitiven und induktiven Schaltungselemente.

**Ansprüche**

1. Analoger Vorverzerrer für die Sende-/Empfangseinrichtungen eines digitalen Nachrichtenübertragungssystems mit komplexer Amplitudenmodulation, insbesondere Quadraturamplitudenmodulation, **gekennzeichnet durch** seine Realisierung mit nur einem Übertragungsweg, mit einem ein- oder mehrstufigen, rückgekoppelten Verstärker, in dessen Rückkopplungsweg eine Nichtlinearität mit signalleistungsabhängigem Gegenkopplungsfaktor eingeschaltet ist.

2. Analoger Vorverzerrer nach Anspruch 1, **gekennzeichnet durch** die Verwendung eines komplexen Gegenkopplungsfaktors.

3. Analoger Vorverzerrer nach Anspruch 1 oder 2, **gekennzeichnet durch** eine Transistorschaltung in Emitter-Grundschaltung als Verstärkungselement.

4. Analoger Vorverzerrer nach Anspruch 3, **dadurch gekennzeichnet,** daß das Gegenkopplungsnetzwerk (Nichtlinearität) zwischen Emitteranschluß und Masse eingeschaltet ist.

5. Analoger Vorverzerrer nach Anspruch 1, **dadurch gekennzeichnet,** daß das Gegenkopplungsnetzwerk zwischen dem Verbindungspunkt eines zwischen Kollektoranschluß und Basisanschluß liegenden ohmschen Spannungsteilers und Masse eingeschaltet ist.

6. Analoger Vorverzerrer nach Anspruch 1 oder 2, **gekennzeichnet durch** eine zweistufige Transistorschaltung in Emitter-Grundschaltung als Verstärkungselement.

7. Analoger Vorverzerrer nach Anspruch 6, **dadurch gekennzeichnet,** daß das Gegenkopplungsnetzwerk zwischen dem über einen ohmschen Widerstand zugleich mit der Basis des ersten Transistors verbundenen Emitter des zweiten Transistors und Masse eingeschaltet ist.

8. Analoger Vorverzerrer nach Anspruch 6, **dadurch gekennzeichnet,** daß das Gegenkopplungsnetzwerk zwischen dem Verbindungspunkt eines zwischen dem Emitter des zweiten und der Basis des ersten Transistors liegenden ohmschen Spannungsteilers und Masse eingeschaltet ist.

9. Analoger Vorverzerrer nach Anspruch 6, **dadurch gekennzeichnet,** daß das Gegenkopplungsnetzwerk zwischen dem Verbindungspunkt eines zwischen dem Kollektor des zweiten und der Basis des ersten Transistors liegenden ohmschen Spannungsteilers und Masse eingeschaltet ist.

10. Analoger Vorverzerrer nach Anspruch 6, **dadurch gekennzeichnet,** daß das Gegenkopplungsnetzwerk zwischen dem über einem ohmschen Widerstand mit dem Kollektor des zweiten Transistors verbundenen Emitter des ersten Transistors und Masse eingeschaltet ist.

11. Analoger Vorverzerrer nach Anspruch 6, **dadurch gekennzeichnet,** daß das Gegenkopplungsnetzwerk zwischen dem Verbindungspunkt eines zwischen dem Kollektor des zweiten und dem Emitter des ersten Transistors liegenden ohmschen Spannungsteilers und Masse eingeschaltet ist.

12. Analoger Vorverzerrer nach Anspruch 1 oder 2, **gekennzeichnet durch** eine einstufige Transistorschaltung in Basis-Grundschaltung als Verstärkungselement.

13. Analoger Vorverzerrer nach Anspruch 12, **dadurch gekennzeichnet,** daß das Gegenkopplungsnetzwerk zwischen dem über einen ohmschen Widerstand mit dem Kollektor verbundenen Basisanschluß und Masse des Transistors eingeschaltet ist.

14. Analoger Vorverzerrer nach Anspruch 12, **dadurch gekennzeichnet,** daß das Gegenkopplungsnetzwerk zwischen dem Verbindungspunkt eines zwischen Kollektor und Basis des Transistors liegenden ohmschen Spannungsteilers und Masse eingeschaltet ist.

15. Analoger Vorverzerrer nach Anspruch 1 oder 2, **gekennzeichnet durch** eine zweistufige Transistorschaltung mit einem ersten Transistor in Basis-Grundschaltung und einem zweiten Transistor in Emitter-Grundschaltung.

16. Analoger Vorverzerrer nach Anspruch 15, **dadurch gekennzeichnet,** daß das Gegenkopplungsnetzwerk zwischen der über einen ohmschen Widerstand mit dem Emitter des zweiten Transistors verbundenen und über einen weiteren ohmschen Widerstand an Masse liegenden Basis des ersten Transistors und Masse eingeschaltet ist.

17. Analoger Vorverzerrer nach Anspruch 15, **dadurch gekennzeichnet,** daß das Gegenkopplungsnetzwerk zwischen dem über einen ohmschen Widerstand mit der Basis des ersten Transistors verbundenen und über einen weiteren ohmschen Widerstand an Masse liegenden Emitter des zweiten Transistors und Masse eingeschaltet ist.

18. Analoger Vorverzerrer nach Anspruch 15, **dadurch gekennzeichnet,** daß das Gegenkopplungsnetzwerk zwischen dem Verbindungspunkt eines zwischen dem Emitter des zweiten Transistors und der Basis des ersten Transistors liegenden ohmschen Spannungsteilers und Masse eingeschaltet ist.

19. Analoger Vorverzerrer nach Anspruch 15, **dadurch gekennzeichnet,** daß das Gegenkopplungsnetzwerk zwischen dem Verbindungspunkt eines zwischen dem Kollektor des zweiten Transistors und dem Emitter des ersten Transistors liegenden ohmschen Spannungsteilers und Masse eingeschaltet ist.

20. Analoger Vorverzerrer nach Anspruch 1 oder 2, **gekennzeichnet durch** eine zweistufige Transistorschaltung mit einem ersten Transistor in Emitter-Grundschaltung und einem zweiten Transistor in Basis-Grundschaltung, bei der das Gegenkopplungsnetzwerk zwischen dem Verbindungspunkt eines zwischen dem Kollektor des zweiten und der Basis des ersten Transistors liegenden ohmschen Spannungsteilers und Masse eingeschaltet ist.

21. Analoger Vorverzerrer nach einem der Ansprüche 1 bis 20, **dadurch gekennzeichnet,** daß das Gegenkopplungsnetzwerk aus einem ohmschen Widerstand, einem Koppelkondensator und der Parallelschaltung aus einem ohmschen Widerstand und einem Diodennetzwerk mit antiparallel liegenden Dioden und einer dazu parallel angeordneten Induktivität und abstimmbaren Kapazität besteht.

22. Analoger Vorverzerrer nach einem der vorhergehenden Ansprüche, **dadurch gekennzeichnet,** daß zusätzliche Kapazitäten zwischen Emitter und Basis und/oder Kollektor und Basis der in Emitter-Grundschaltung betriebenen Transistoren eingeschaltet sind.

23. Analoger Vorverzerrer nach einem der vorhergehenden Ansprüche, **dadurch gekennzeichnet,** daß anstelle von einstellbaren Kondensatoren Varaktordioden eingesetzt sind.

24. Analoger Vorverzerrer nach einem der vorhergehenden Ansprüche, **dadurch gekennzeichnet,** daß das Gegenkopplungsnetzwerk mit einer Transistorschaltung realisiert ist.

25. Analoger Vorverzerrer nach einem der Ansprüche 21 bis 24, **dadurch gekennzeichnet,** daß die antiparallelen Dioden an einem Verbindungspunkt zwischen einer der Dioden und einem auf Masse führenden Koppelkondensator mit einer Gleichspannung vorgespannt sind.

26. Analoger Vorverzerrer nach Anspruch 25, **dadurch gekennzeichnet,** daß ein ohmscher Widerstand zum Koppelkondensator parallelgeschaltet ist.

27. Analoger Vorverzerrer nach einem der Ansprüche 21 bis 24, **dadurch gekennzeichnet,** daß zu einem zwischen einer der beiden antiparallelen Dioden und Masse liegenden Koppelkondensator ein ohmscher Widerstand parallelgeschaltet ist.

FIG 1

FIG 2

FIG 3

FIG 4

FIG 5

FIG 6

FIG 7

**FIG 8**

**FIG 9**

**FIG 10**

FIG 11

FIG 12

FIG 13

FIG 14

FIG 15

EP 0 391 235 A1

FIG 16

FIG 17

FIG 18

FIG 19

FIG 20

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | 1985 IEEE-MTT-S INTERNATIONAL MICROWAVE SYMPO-SIUM DIGEST, St. Louis, Missouri, 4-6 Juni 1985 Seiten 99-102, IEEE, New York, us; M. NANNICINI et al. :"Temperature controlled predistortion circuits for 64 QAM microwave power amplifiers" * Figuren 3,7; Seite 100 * | 1, 3, 4 | H03F1/32 H03G7/08 |
| Y | US-A-4600847 (P.N.BAUM) * Spalte 2, Zeile 59 - Spalte 4, Zeile 4; Figuren 1-3 * | 1, 3, 4 | |
| A | US-A-3397324 (L.T.FINE ET AL.) * Spalte 4, Zeilen 13 - 52; Figur * | 1-4, 25 | |
| A | US-A-3289107 (N.A.ZELLMER ET AL.) * Spalte 4, Zeilen 40 - 72; Figuren 3-5 * | 1-4, 19 | |
| A | FR-A-2146889 (THE MARCONI CO. LTD) * Seite 7, Zeilen 1 - 8; Figur 12 * | 8, 9, 11, 14, 18, 20 | |
| A | US-A-3223937 (L.J. MCDONALD) * Spalte 4, Zeilen 3 - 63; Figur 2 * | 1-3, 25-27 | RECHERCHIERTE SACHGEBIETE (Int. Cl.5 ) H03F H03G |

Der vorliegende Recherchenbericht wurde für alle Patentansprüche erstellt

| Recherchenort | Abschlußdatum der Recherche | Prüfer |
|---|---|---|
| DEN HAAG | 14 JUNI 1990 | TYBERGHIEN G.M. |